# EUROPEAN PATENT APPLICATION

(11) **EP 4 600 736 A1**
(43) Date of publication of application: **13.08.2025**
(21) Application number: 23875282.8
(22) Date of filing: 10.10.2023
(51) Int. Cl.: G03F 1/62, G03F 1/22

(54) **MANUFACTURING METHOD OF GRAPHENE MEMBRANE PELLICLE FOR EXTREME ULTRA VIOLET LITHOGRAPHIC APPARATUS**

(30) Priority: 07.10.2022 KR 20220128693
(71) Applicant: Charmgraphene Co., Ltd., Suwon-si, Gyeonggi-do 16648 (KR)
(72) Inventor: KIM, Yong Ki, Suwon-si Gyeonggi-do 16648 (KR)
(74) Representative: Habermann, Hruschka & Schnabel
(86) International application number: PCT/KR2023/015492
(87) International publication number: WO 2024/076221

(57) **Abstract**

The present invention pertains to a manufacturing method of a graphene membrane pellicle for an extreme ultra violet (EUV) lithographic apparatus. The present invention provides a manufacturing method of a graphene membrane pellicle for an EUV lithographic apparatus, whereby a pellicle for protecting photomasks in an EUV lithographic apparatus using a graphene-deposited catalytic metal film can be produced. A graphene membrane pellicle produced by this graphene membrane pellicle manufacturing method uses layered graphene and thus has the advantage of being adjustable in thickness.

## Description

### Technical Field

The present invention relates to a manufacturing method of graphene membrane pellicle for EUV (Extreme Ultraviolet) lithographic apparatus, and more specifically, to a manufacturing method of graphene membrane pellicle for EUV lithographic apparatus to protect the photomask, using a catalyst metal film on which graphene is deposited.

### Background Art

Generally, graphene is a material having a two-dimensional planar structure having a honeycomb shape in which carbons are connected with each other in the form of a hexagonal shape, and has a very large feature that its thickness is very thin and transparent, and electric conductivity is very high. Graphene is extremely thin, with a thickness of 0.2 nm, which gives it high transparency. It can conduct 100 times more current than copper at room temperature and transmit signals 100 times faster than silicon. Moreover, graphene's thermal conductivity is more than twice as high as that of diamond, which is known for having the best thermal conductivity.

Graphene can be produced using the chemical vapor deposition (CVD) method, where process gases are deposited onto a metal catalyst film supplied in a roll-to-roll manner to mass-produce high-quality graphene.

Graphene has mechanical strength more than 200 times that of steel, yet it is highly flexible, allowing it to stretch or fold without losing electrical conductivity. Due to these outstanding properties, graphene is recognized as a key material for future technologies such as flexible displays, transparent displays, and wearable computers. Recently, there have also been efforts to use graphene as a pellicle to protect the photomasks used in lithographic apparatus. Photomasks have fine circuit patterns formed on them, and these patterns are transferred onto silicon wafers via lithographic apparatus. However, if dust particles from the air adhere to the photomask, these particles can also be transferred onto the silicon, causing defects in the product.

In particular, extreme ultraviolet (EUV) lithographic apparatus forms extremely fine circuit patterns of just a few nanometers on photomasks, using extreme ultraviolet light to transfer these patterns onto silicon wafers. Using EUV light in the exposure process allows for the production of more detailed semiconductor circuit patterns, reducing the number of process steps, increasing productivity, and enabling the creation of high-performance chips.

As a result, alongside the development of EUV lithographic apparatus, there is intensifying competition in the development of pellicles that not only protect photomasks but also shield them from airborne contamination to reduce defects in silicon wafers.

A pellicle is a thin membrane structure placed over the photomask to prevent the attachment of foreign particles, protecting the photomask while also defocusing the image of any particles, thereby preventing defects in the circuit pattern transferred to the silicon wafer. In conventional optical projection lithographic apparatus, the pellicle is a fixed structure that is replaced at appropriate intervals, reducing the cost of mask cleaning or replacement and increasing process efficiency.

However, in the case of EUV lithographic apparatus, the shorter wavelength of EUV light leads to most of the light being absorbed by conventional organic pellicles, which poses several challenges for their use.

As a result, certain prerequisites are required for EUV lithography pellicles. The key requirements for EUV pellicles include 1) high transmittance of over 90%, 2) mechanical stability, and 3) minimal thermal deformation etc. Consequently, EUV pellicles must maintain over 90% transmittance and mechanical stability with a thickness of 60 nm or less. Materials such as polysilicon, CNT, graphene, and silicon carbide (SiC) have emerged as candidates for these membranes, and patent applications related to these technologies are on the rise.

### Disclosure

### Technical Problem

To solve the aforementioned issues, the present invention aims to provide a method for manufacturing a graphene membrane pellicle for EUV lithographic apparatus by laminating and transferring a graphene film obtained through chemical vapor deposition (CVD) and attaching it to the pellicle frame of EUV lithographic apparatus, making it suitable for use in EUV lithography processes.

### Technical Solution

To achieve the aforementioned objective, the present invention provides a manufacturing method of a graphene membrane pellicle for EUV lithographic apparatus, comprising: (a) A graphene stacking film formation step in which the graphene from a graphene-deposited film, with graphene deposited on a catalytic metal foil, is transferred onto a thermal release tape and repetitively laminated to form stacked graphene; (b) A graphene transfer film formation step in which the thermal release tape of the graphene stacking film is attached to a substrate film and the thermal release tape is thermally separated, thereby transferring the stacked graphene onto the substrate film; (c) A stacked graphene heat treatment step in which a certain amount of heat is applied to the graphene transfer film to enhance the stacked graphene; (d) A graphene transfer film cutting step in which the graphene transfer film with the enhanced stacked graphene is cut to a specified size according to the specifications of the pellicle frame; (e) A graphene membrane formation step in which the substrate film is removed from the cut graphene transfer film, and the enhanced stacked graphene is separated to form a graphene membrane; and (f) A graphene membrane attachment step in which the graphene membrane is attached to the pellicle frame.

In the present invention, step (a) comprises: (a-1) Attaching the graphene deposition surface of the graphene-deposited film to the thermal release tape; (a-2) Immersing the thermal release tape with the attached graphene-deposited film into an etching solution to remove the catalytic metal foil and transfer the graphene onto the thermal release tape; (a-3) Washing the thermal release tape with the transferred graphene; and (a-4) Repeating steps (a-1) through (a-3) for n cycles to form a stacked graphene on the thermal release tape, with the graphene laminated n times to form the stacked graphene; wherein the graphene stacking film is formed on the thermal release tape with the stacked graphene.

In the invention, the number of cycles, n, is between 2 and 100, and the thickness of the stacked graphene is between 5 and 100 nm.

In the invention step (a) further comprises: (a-5) Attaching a capping material-deposited film, in which a capping material is deposited on the catalytic metal foil, to the stacked graphene surface of the graphene stacking film; (a-6) Immersing the graphene stacking film with the attached capping material-deposited film into an etching solution to remove the catalytic metal foil and form a capping layer on the surface of the stacked graphene; and (a-7) Washing the graphene stacking film with the formed capping layer.

In the invention, step (c) comprises: (c-1) A residue treatment step of heating the graphene transfer film to a certain temperature to remove the residuals of the thermal release tape remaining on the stacked graphene; and (c-2) A stacked graphene enhancement step of enlarging the graphene crystal size or depositing additional graphene on the residue-treated graphene transfer film.

In the invention step (c) further comprises: (c-3) A capping layer formation step of depositing a capping material on the surface of the enhanced stacked graphene of the graphene transfer film to form a capping layer.

In the invention, the substrate film is made of Cu or Ni.

In the invention, step (f) comprises: (f-1) Preparing the pellicle frame for attaching the graphene membrane; (f-2) Placing the graphene membrane horizontally on the surface of a tank filled with an aqueous solution; (f-3) Vertically inserting the pellicle frame into the aqueous solution; and (f-4) Lifting the pellicle frame vertically from the aqueous solution, attaching the graphene membrane from the top to the bottom of the membrane attachment surface of the pellicle frame.

In the invention, the pellicle frame comprises: a frame body with a flat front and back, a through-hole formed in the center of the frame body, and an inclined surface part formed around the through-hole on the front of the frame body, wherein the angle between the inclined surface part and the back of the frame body is formed as an acute angle.

In the invention, the graphene membrane is attached to the inclined surface part on the front or the back of the frame body to cover the through-hole.

In the invention, the pellicle frame comprises: a frame body with a flat front and back, a through-hole formed in the center of the frame body, a front inclined surface part formed around the through-hole on the front of the frame body, and a rear inclined surface part formed around the through-hole on the back of the frame body.

In the invention, the front inclined surface part comprises: an upper front inclined surface part, a lower front inclined surface part spaced a certain distance from the upper front inclined surface part, and side inclined surface part connecting both sides of the upper and lower inclined surfaces to form an inclined surface, wherein the angle between the front inclined surface part and the front of the frame body is formed as an acute angle, and wherein the graphene membrane is attached to the front inclined surface part to cover the through-hole.

In the invention, the rear inclined surface part comprises: an upper rear inclined surface part, a lower rear inclined surface part spaced a certain distance from the upper rear inclined surface part, and side inclined surface part connecting both sides of the upper and lower inclined surfaces to form an inclined surface, wherein the angle between the rear inclined surface part and the back of the frame body is formed as an acute angle, and wherein the graphene membrane is attached to the rear inclined surface part to cover the through-hole.

In the invention, the graphene membrane has an extreme ultraviolet transmittance of 92 to 96% at a wavelength of 13.5 nm.

### Advantageous Effects

The graphene membrane pellicle for EUV lithographic apparatus according to the present invention allows for the production of a graphene membrane with adjustable thickness due to the use of stacked graphene.

Additionally, the graphene membrane pellicle for EUV lithographic apparatus according to the present invention has the advantage of being able to compensate for defects that occur during the stacking process.

Furthermore, the graphene membrane pellicle for EUV lithographic apparatus according to the present invention can attach the graphene membrane to both sides of the pellicle frame, allowing for a thinner graphene stack, which reduces both the cost and labor associated with stacking graphene.

Moreover, the graphene membrane pellicle for EUV lithographic apparatus according to the present invention has the advantage of being able to adjust the thickness of the graphene, allowing it to achieve the appropriate transmittance for EUV lithographic apparatus.

In addition, the graphene membrane pellicle for EUV lithographic apparatus according to the present invention has the advantage of minimizing product defects in the photomask process due to the adequate mechanical strength and high transmittance of the graphene membrane.

Finally, the graphene membrane pellicle for EUV lithographic apparatus according to the present invention has the advantage that, even if the graphene membrane ruptures, the nature of the graphene membrane makes it highly unlikely that fragments will damage the lithographic apparatus.

### Description of Drawings

Fig. 1 is a flowchart of the manufacturing method of a graphene membrane pellicle for EUV lithographic apparatus according to the present invention.
Fig. 2 is a structural diagram of a graphene stacking apparatus for laminating graphene in the manufacturing method of a graphene membrane pellicle for EUV lithographic apparatus according to the present invention.
Fig. 3 is an enlarged view of part of the graphene stacking apparatus in Fig. 2.
Fig. 4 is a structural diagram of a graphene-deposited film and a capping material-deposited film used in the present invention.
Fig. 5 is a structural diagram of the transfer apparatus showing the transfer of the stacked graphene from the thermal release tape to the substrate film in the present invention.
Figs. 6a and 6b are structural diagrams showing the transfer of graphene from the thermal release tape to the substrate film via the transfer apparatus in Fig. 5.
Figs. 7a and 7b are structural diagrams showing the graphene transfer film after heat treatment, transferred onto the substrate film.
Fig. 8 is a plan view of the standardized graphene membrane with the substrate film removed, according to the present invention.
Fig. 9 is a perspective view of the pellicle frame to which the graphene membrane is attached, according to the present invention.
Fig. 10 is a cross-sectional view of the first and second embodiments of the pellicle frame to which the graphene membrane is attached, according to the present invention.
Fig. 11 is a cross-sectional view showing the graphene membrane attached to the rear side part of the pellicle frame in Fig. 10.
Fig. 12 is a cross-sectional view showing the graphene membrane attached to the inclined surface part on the front side of the pellicle frame in Fig. 10.
Fig. 13 is a flowchart illustrating the process of attaching the graphene membrane to one side of the pellicle frame, according to the present invention.
Fig. 14 is a cross-sectional view showing that the edge of the inclined surface of the pellicle frame is formed at an acute angle, according to the present invention.
Fig. 15 is a cross-sectional view of the third and fourth embodiments of the pellicle frame to which the graphene membrane is attached, according to the present invention.
Fig. 16 is a cross-sectional view showing the graphene membrane attached to the pellicle frame of the embodiment in Fig. 15.
Fig. 17 is a flowchart diagram illustrating the process of attaching the graphene membrane to both sides of the pellicle frame, according to the present invention.
Fig. 18 is a cross-sectional view showing that the edges of the front and rear inclined surfaces of the pellicle frame are formed at acute angles, according to the present invention.

### Mode for Disclosure

Hereinafter, preferred embodiments of the present invention will be described in detail with reference to the accompanying drawings. However, this is merely for the purpose of providing a detailed explanation to enable those skilled in the art to easily carry out the invention, and it is not intended to limit the technical spirit and scope of the present invention.

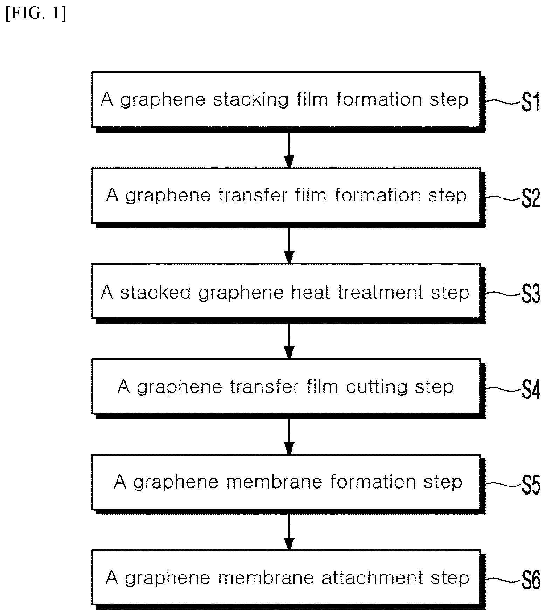

Fig. 1 is a flowchart of the manufacturing method of a graphene membrane pellicle for EUV lithographic apparatus according to the present invention. As shown in the drawing, the manufacturing method of a graphene membrane pellicle according to the present invention , comprising: (a) A graphene stacking film formation step in which the graphene from a graphene-deposited film, with graphene deposited on a catalytic metal foil, is transferred onto a thermal release tape and repetitively laminated to form stacked graphene(S1); (b) A graphene transfer film formation step in which the thermal release tape of the graphene stacking film is attached to a substrate film and the thermal release tape is thermally separated, thereby transferring the stacked graphene onto the substrate film(S2); (c) A stacked graphene heat treatment step in which a certain amount of heat is applied to the graphene transfer film to enhance the stacked graphene(S3); (d) A graphene transfer film cutting step in which the graphene transfer film with the enhanced stacked graphene is cut to a specified size according to the specifications of the pellicle frame(S4); (e) A graphene membrane formation step in which the substrate film is removed from the cut graphene transfer film, and the enhanced stacked graphene is separated to form a graphene membrane(S5); and (f) A graphene membrane attachment step in which the graphene membrane is attached to the pellicle frame(S6). Each step will now be described in detail with reference to the drawings.

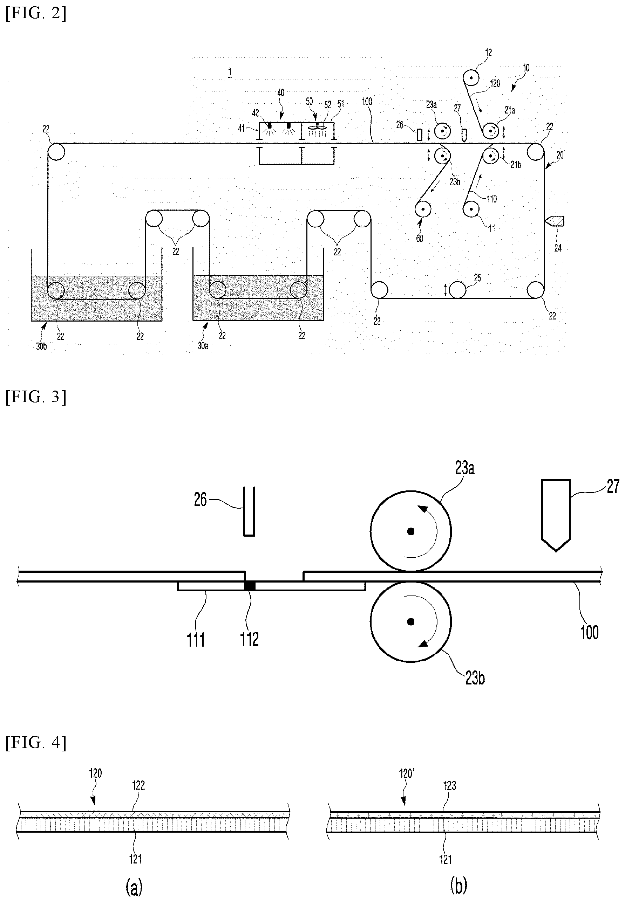

First, in the graphene stacking film formation step (S1), graphene (122) from a graphene-deposited film (120), which has graphene deposited on a catalytic metal foil (121), is transferred onto a thermal release tape (110) and repetitively laminated to form stacked graphene (122'). Fig. 2 shows a graphene stacking apparatus (1), and Fig. 4(a) shows the structure of the graphene-deposited film (120). As shown in Fig. 4, the graphene-deposited film (120) consists of graphene (122) and a catalytic metal foil (121) on which graphene (122) is deposited. The graphene stacking film formation step specifically includes: Step (S11), where the graphene deposition surface of the catalytic metal foil (121) with the deposited graphene (122) is attached to the thermal release tape (110); Step (S12), where the catalytic metal foil (121) is removed through etching from the graphene-deposited film (120) attached to the thermal release tape (110), transferring and laminating the graphene (122) onto the thermal release tape (110); Step (S13), where the thermal release tape (110), with the catalytic metal foil (121) removed, is washed; Step (S14), where steps (S11) to (S13) are repeated for n cycles. Graphene (122) is deposited on the catalytic metal foil (121) by a chemical vapor deposition (CVD) method. The step of laminating graphene (122) onto the thermal release tape (110) will now be described in detail with reference to the graphene stacking apparatus (1) shown in Fig. 2. The graphene-deposited film (120) is supplied in a rolled state, and it is supplied via the graphene-deposited film supply roller (12) shown in Fig. 2. The graphene deposition surface of the graphene-deposited film (120) supplied by the supply roller (12) is attached to the thermal release tape (110) supplied by the thermal release tape supply roller (11). The graphene-deposited film (120) attached to the thermal release tape (110) is continuously laminated as it rotates via the driving rollers (21, 23). In the laminating process, the graphene-deposited film (120) is first attached to the thermal release tape (110), and the catalytic metal foil (121) is etched in the etching unit (30), transferring the graphene (122) onto the thermal release tape (110). This process is repeated n times until the desired thickness is achieved. In other words, the graphene deposition surface of the graphene-deposited film (120) is attached to the graphene stacking surface of the thermal release tape (110), and the catalytic metal foil (121) is removed by etching. By repeating this process, the graphene (122) is transferred and laminated onto the thermal release tape (110), forming stacked graphene (122') in n cycles. "n" represents the number of lamination cycles required to achieve the desired thickness of the stacked graphene. Since the stacked graphene (122') is an ultra-thin film, the number of laminating cycles can be finely controlled to achieve a precise thickness. The stacked graphene (122') laminated n times on the thermal release tape (110) forms the graphene stacking film (100). After the formation of stacked graphene (122'), a step to form a capping layer on the stacked graphene may be included. The capping layer formation step includes: Step (S15), where a capping material-deposited film (120'), in which a capping material (123) is deposited on a catalytic metal foil (121), is attached to the surface of the stacked graphene (122') of the graphene stacking film (100); Step (S16), where the catalytic metal foil (121) of the capping material-deposited film (120') is removed through etching, transferring and laminating the capping layer (123) onto the surface of the stacked graphene (122'); Step (S17), where the graphene stacking film with the formed capping layer (123) is washed. The capping material-deposited film (120') consists of a catalytic metal foil (121) and a capping layer (123) deposited as a capping material, as shown in Fig. 4(b). Since the capping layer (123) is to be transferred and laminated onto the stacked graphene (122'), the catalytic metal foil (121) is removed through etching, and the capping layer (123) is transferred and laminated onto the stacked graphene (122'). The capping material can be nano-graphite, carbon nano-sheet, carbon nanotube, SiC (silicon carbide), or B4C (boron carbide). Once the graphene stacking film (100) with the stacked graphene laminated n times is completed, it is cut by the cutter (27), and the cut graphene stacking film (100) is wound onto a winding roller (60). Once the winding of the graphene stacking film (100) is complete on the winding roller (60), the winding roller (60) is retrieved from the graphene stacking apparatus (1). The number of lamination cycles, n, for laminating the graphene can range from 2 to 100 cycles, and the thickness of the stacked graphene (122') laminated n times can range from 5 to 100 nm.

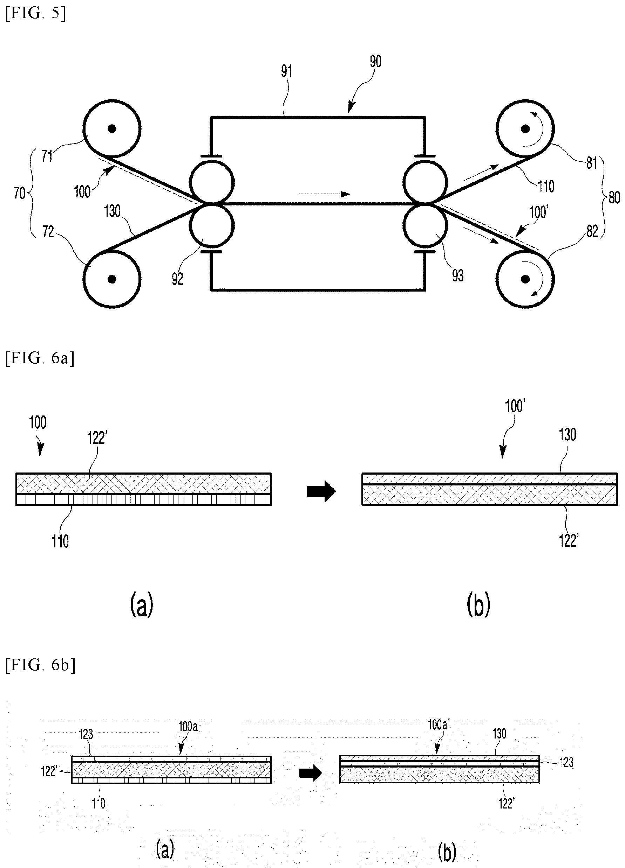

Next, the thermal release tape (110) of the graphene stacking film (100) is attached to a substrate film (130), and the thermal release tape (110) is thermally separated, transferring the stacked graphene (122') onto the substrate film (130) in the graphene transfer film formation step (S2). Since the thermal release tape (110) separates from the stacked graphene (122') upon the application of heat, the thermal release tape (110) is removed by applying heat, and the stacked graphene (122') is transferred onto the substrate film (130), forming the graphene transfer film (100'). Fig. 5 shows a thermal transfer apparatus (90) for removing the thermal release tape (110) from the graphene stacking film (100) and transferring the stacked graphene (122') onto the substrate film (130). As the graphene stacking film (100) and substrate film (130) pass through heating rollers (92, 93), the thermal release tape (110) and stacked graphene (122') separate from each other, and the stacked graphene (122') is transferred onto the substrate film (130), forming the graphene transfer film (100'). Fig. 6a(a) shows the graphene stacking film (100) before the stacked graphene (122') is transferred, and Fig. 6a(b) shows the graphene transfer film (100') after the stacked graphene (122') has been transferred onto the substrate film (130). As shown in Fig. 6a, the stacked graphene (122') is transferred from the graphene stacking film (100) to the graphene transfer film (100') via thermal transfer. The catalytic metal foil and the substrate film used in this process may be made of copper (Cu) or nickel (Ni). Fig. 6b(a) shows a graphene stacking film (100a) with the capping layer (123) transferred onto the stacked graphene (122'), and Fig. 6b(b) shows the graphene transfer film (100a') formed by transferring the capping layer (123) and stacked graphene (122') onto the substrate film (130). Fig. 6b is the same as Fig. 6a, except for the addition of the capping layer (123). Therefore, the stacked graphene (122') and capping layer (123) are thermally transferred from the thermal release tape (110) onto the substrate film (130). As a result, the graphene stacking film (100a) is thermally transferred onto the substrate film, forming the graphene transfer film (100a').

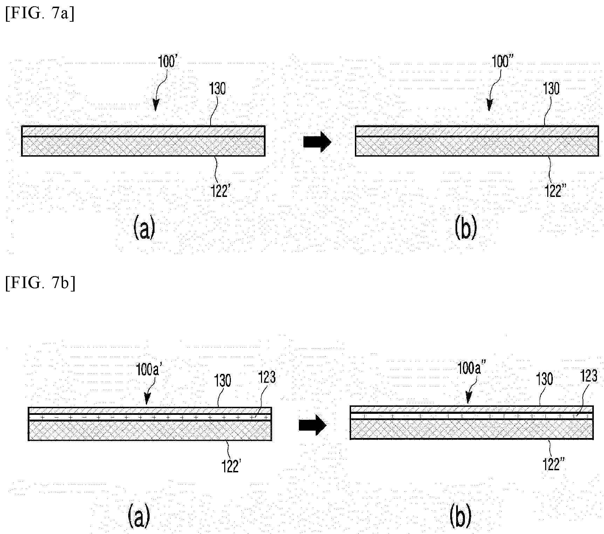

Next, the stacked graphene (122') on the graphene transfer film (100') undergoes a heat treatment step (S3), where a certain amount of heat is applied to perform post-heat treatment on the stacked graphene (122'). The heat treatment step (S3) consists of: a residue treatment step (S31), where the graphene transfer film (100') is heated to a specific temperature to remove the residuals of the thermal release tape (110) left on the stacked graphene (122'); a stacked graphene enhancement step (S32), where the crystal size of the stacked graphene (122') is enlarged or additional graphene is deposited to correct defects in the graphene. Each step will be explained in detail. First, the upper surface of the stacked graphene (122') transferred onto the substrate film (130) undergoes a step to remove the residuals of the thermal release tape. Organic materials from the thermal release tape (110) may remain on the attachment surface of the graphene transfer film (100'). Since these organic materials could damage the graphene membrane if left untreated, it is preferable to remove them beforehand. To do this, the graphene transfer film (100') is heat-treated at a temperature between 300 and 400°C to burn off and remove the organic materials that remain on the attachment surface of the thermal release tape. Next, the stacked graphene enhancement step involves enlarging the graphene crystals or depositing additional graphene to correct defects in the stacked graphene (122'). The graphene transfer film (100') is placed in a graphene deposition apparatus (not shown) to enhance the stacked graphene (122'). The enlargement of graphene crystals or the deposition of additional graphene is performed in the deposition chamber of the graphene deposition apparatus, where deposition gases such as CH4, C2H6, or H2 are introduced. This process corrects defects in the stacked graphene (122'). Fig. 7a(a) shows the state after heat treatment, where the organic materials remaining on the attachment surface of the thermal release tape have been removed. Fig. 7a(b) shows the graphene transfer film (100") with the enhanced stacked graphene (122") after completing the deposition and enhancement process. As a result, the graphene transfer film (100") consists of the substrate film (130) and the enhanced stacked graphene (122"). Additionally, Fig. 7b(a) shows the graphene transfer film (100a') before heat treatment, where the substrate film (130) is attached to the stacked graphene (122') and the capping layer (123). Fig. 7b(b) shows the graphene transfer film (100a") after the enhancement of the stacked graphene (122") through heat treatment. In the case of Fig. 7a, the heat treatment can be followed by the deposition of the capping layer (123) in the deposition chamber to form the capping layer (123) on the enhanced stacked graphene (122"). The capping materials may include nano-graphite, carbon nano sheet, carbon nanotube, SiC (silicon carbide), and B4C (boron carbide).

Next, the enhanced stacked graphene (122") formed on the graphene transfer film (100") is cut to a specified size according to the specifications of the pellicle frame (300) in the graphene transfer film cutting step (S4). Since the enhanced stacked graphene (122") is now suitable for use as a graphene membrane (200), the graphene transfer film (100") is cut to a size that matches the pellicle frame (300). Typically, the pellicle frame (300) is rectangular in shape, so the film can be cut into a rectangular shape.

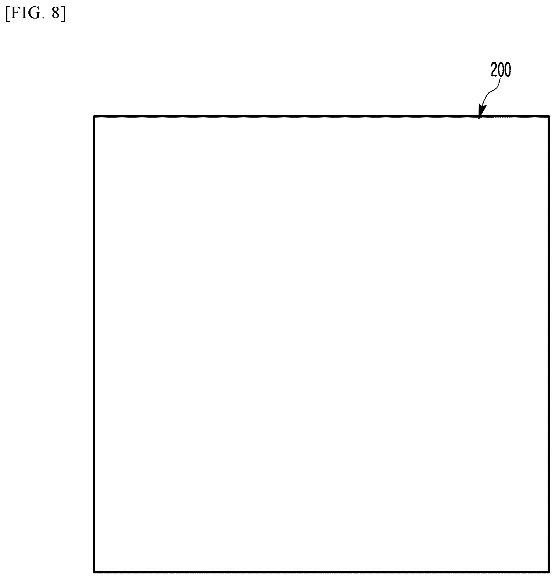

Next, in the graphene membrane formation step (S5), the substrate film (130) is removed from the cut graphene transfer film (100"), and the enhanced stacked graphene (122") is separated to form the graphene membrane (200). Once the graphene transfer film (100") has been cut to the appropriate shape, the metal substrate film (130) of the graphene transfer film (100") is removed through etching, leaving only the enhanced stacked graphene (122") to form the graphene membrane (200). The cut graphene transfer film (100") is placed into a bath filled with etching solution to remove the metal substrate film (130) via etching. Once the substrate film (130) has been removed by the etching solution, only the enhanced stacked graphene (122") remains, forming the graphene membrane (200). Fig. 8 shows the graphene membrane (200). The graphene membrane (200) can have a thickness ranging from 10 to 100 nm and an extreme ultraviolet transmittance of 92 to 96% at a wavelength of 13.5 nm. The graphene membrane (200) may also include a capping layer (210).

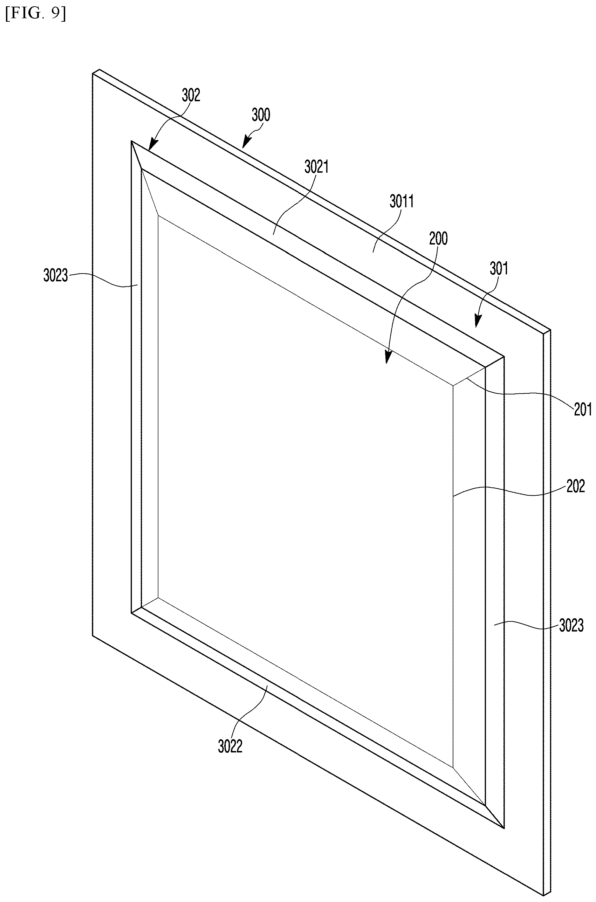

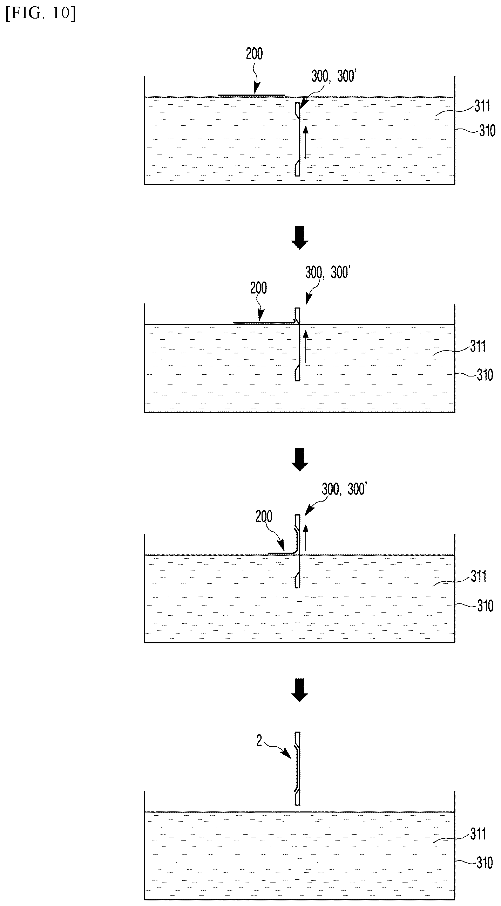

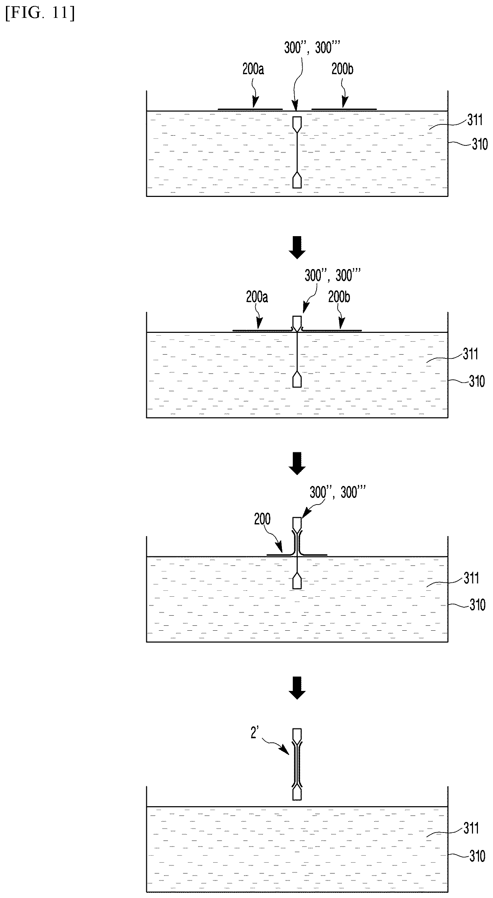

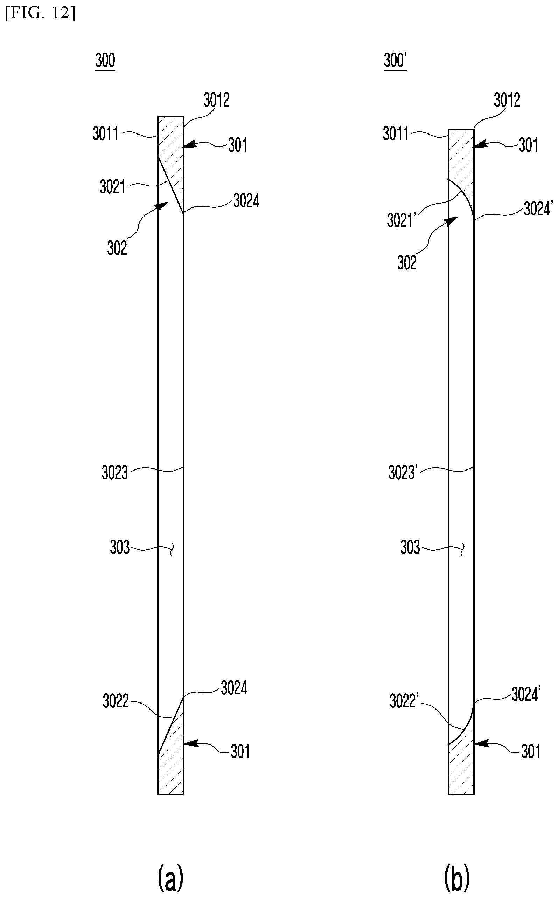

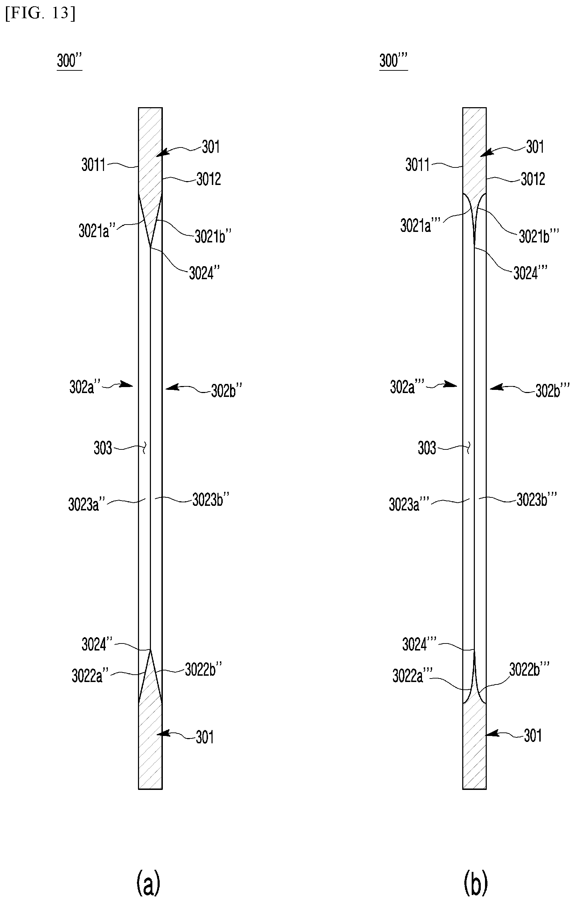

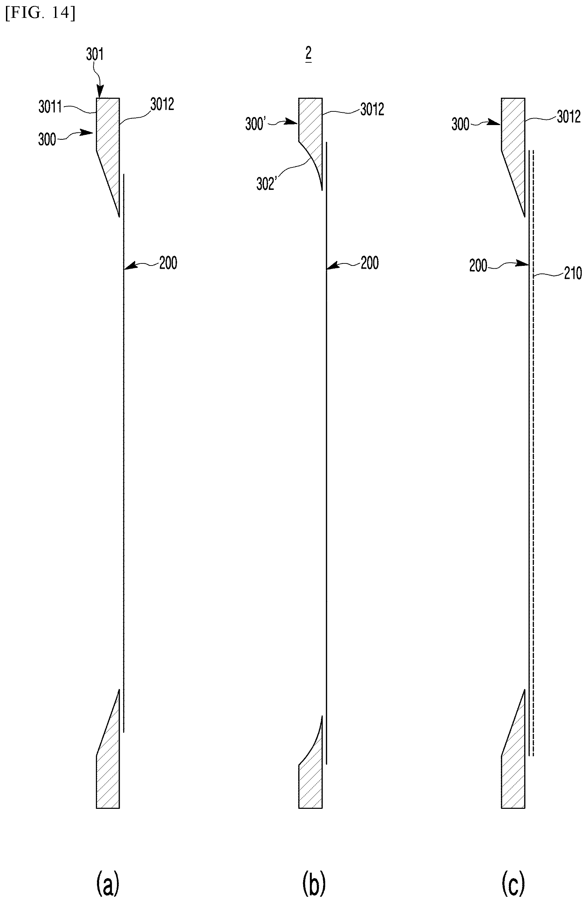

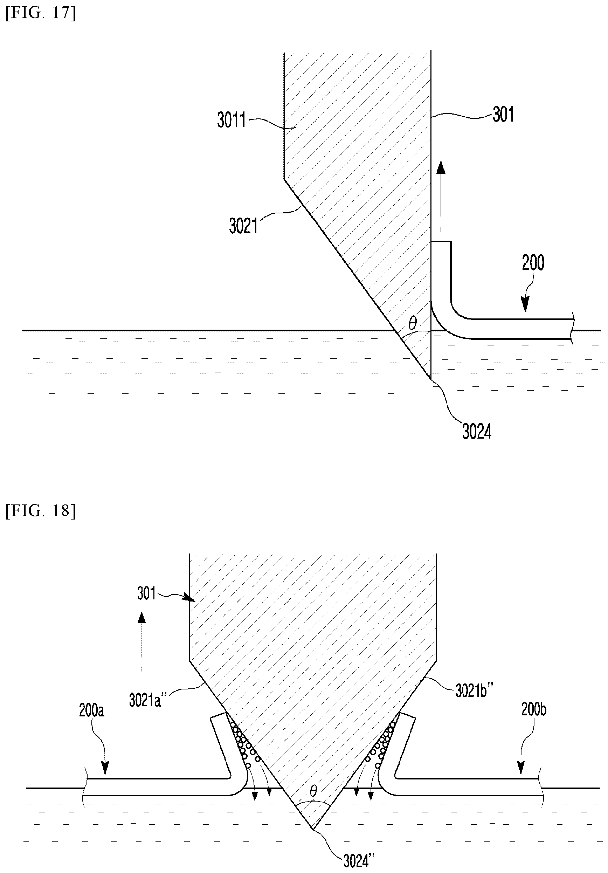

Next, the graphene membrane (200) undergoes the graphene membrane attachment step (S6), where it is attached to the pellicle frame (300). Fig. 9 shows the graphene membrane (200) attached to the pellicle frame (300), and Figs. 10 and 11 illustrate the process of attaching the graphene membrane (200) to pellicle frames (300, 300', 300", 300"'). Fig. 10 shows the process of attaching the graphene membrane (200) to one side of the pellicle frames (300, 300'), while Fig. 11 shows the process of attaching the graphene membrane (200) to both sides of the pellicle frames (300", 300"'). Fig. 12 illustrates the first and second embodiments of the pellicle frames (300, 300'), and Fig. 13 illustrates the third and fourth embodiments of the pellicle frames (300", 300"'). Figs. 14 to 16 show the graphene membrane (200) attached to various embodiments (300, 300', 300", 300"') of the pellicle frame. Figs. 17 and 18 show that the inclined edges form an acute angle (θ). Below, the process of attaching the graphene membrane to the pellicle frame will be explained with reference to Figs. 10 to 18.

First, the pellicle frame is prepared (S61) to allow the attachment of the graphene membrane. The pellicle frame is prepared in the form shown in Figs. 12 and 13.

As shown in Fig. 12(a), the pellicle frame (300) in the first embodiment consists of a frame body (301) with a flat front and back, an inclined surface part (302) formed at the center of the front side of the frame body (301), and a through-hole (303) formed on the front side of the frame body (301). The inclined surface part (302) consists of an upper inclined surface part (3021), a lower inclined surface part (3022) spaced at a certain distance from the upper inclined surface (3021), and side inclined surface part (3023) that connect the upper and lower inclined surface part. As shown in the figure, the inclined surface parts are straight lines. Fig. 12(b) shows the pellicle frame (300') of the second embodiment, which is also composed of a frame body (301) with a flat front and back, an inclined surface part (302') formed at the center of the front side of the frame body (301), and a through-hole (303) formed on the front of the frame body (301). The difference between the second embodiment (300') and the first embodiment (300) lies in the inclined surface part (302'). The inclined surface part (302') in the second embodiment (300') consists of an upper inclined surface part (3021'), a lower inclined surface part (3022') spaced at a certain distance from the upper inclined surface part (3021'), and side inclined surface part (3023') connecting the upper and lower inclined surface part on both sides. Since the inclined surface part is curved, no fold line may form where the upper inclined surface part (3021') and lower inclined surface part (3022') meet the side inclined surface part (3023'). As a result, no fold lines may form when the graphene membrane (200) is attached at the point where the inclined surface part meets. As shown in Fig. 17, the angle (θ) formed by the edge (3024, 3024') where the inclined surface part (302, 302') meets the back side (3012) is an acute angle. Forming the edge of the inclined surface part at an acute angle (θ) ensures that the solution does not accumulate on the edge (3024, 3024') of the inclined surface part when attaching the graphene membrane (200) and allows the solution to drip downwards under gravity. Additionally, the sharp edge prevents droplets from forming on the inclined surface part. If the edge of the inclined surface is not formed at an acute angle, droplets may accumulate at the junction between the front inclined surface part (302) and the back side (3012), and the surface tension of the droplets may pull the graphene membrane (200), causing damage. The acute angle can be 45° or less.

Figs. 13(a) and 13(b) show the third embodiment (300") and the fourth embodiment (300"') of the pellicle frame. The pellicle frame (300") in Fig. 13(a) consists of a frame body (301) with a flat front and back, a through-hole (303) formed in the center of the frame body, a front inclined surface part (302a") formed around the through-hole (303) on the front of the frame body (301), and a rear inclined surface part (302b") formed around the through-hole (303) on the back of the frame body (301). The front inclined surface part (302a") consists of an upper front inclined surface part (3021a"), a lower front inclined surface part (3022a") spaced at a certain distance from the upper front inclined surface part (3021a"), and side inclined surface part (3023a") connecting the upper and lower inclined surface part on both sides. The rear inclined surface part (302b") is identical to the front inclined surface part (302a"). The rear inclined surface part (302b") consists of an upper rear inclined surface part (3021b"), a lower rear inclined surface part (3022b") spaced at a certain distance from the upper rear inclined surface part (3021b"), and side inclined surface part (3023b") connecting the upper and lower inclined surface part on both sides. In the third embodiment (300"), both the front and rear inclined surface parts are straight lines. The fourth embodiment (300"') of the pellicle frame in Fig. 13(b) is similar in structure to the third embodiment (300"), but the difference lies in the curved inclined surface part. Specifically, the front inclined surface part (302a"') consists of an upper front inclined surface part (3021a"'), a lower front inclined surface part (3022a"') spaced at a certain distance from the upper front inclined surface part (3021a"'), and side inclined surface part (3023a"') connecting the upper and lower inclined surface part on both sides. The rear inclined surface part (302b"') has a corresponding structure to the front inclined surface part (302a"'). It consists of an upper rear inclined surface part (3021b"'), a lower rear inclined surface part (3022b"') spaced at a certain distance from the upper rear inclined surface part (3021b"'), and side inclined surface part (3023b"') connecting the upper and lower inclined surface part on both sides. Since the inclined surface part is curved, no fold lines may form at the point where the upper and lower inclined surface part meets the side inclined surface part. This is identical for both the front inclined surface part (3021a"') and the rear inclined surface part (302b"'). As shown in Fig. 18, the edge (3024", 3024"') where the inclined surface part meets is formed at an acute angle (θ) in both the straight and curved embodiments of the inclined surface part, resulting in a sharp edge. Forming the edge (3024", 3024"') at an acute angle prevents water droplets from accumulating at the edge of the inclined surface part.

Next, as shown in Figs. 10 and 11, the graphene membrane (200) is floated horizontally on the surface of a water tank (300) filled with an aqueous solution (311). When the graphene membrane (200) is floated horizontally on the solution (311), it remains suspended on the surface of the solution. A doping solution may also be added to the solution.

Next, as shown in Figs. 10 and 11, the pellicle frame (300, 300', 300", 300‴) is vertically inserted into the solution (401). The process of inserting the pellicle frame into the solution and floating the graphene membrane in the solution can be performed either by floating the graphene membrane first and then vertically inserting the pellicle frame, or by vertically inserting the pellicle frame first and then floating the graphene membrane in the solution. This order of steps is obvious to those skilled in the art and does not limit the invention.

Next, as shown in Figs. 10 and 11, the pellicle frame (300, 300', 300", 300‴) inserted into the solution is lifted vertically, attaching the graphene membrane (200) to the membrane attachment surface of the pellicle frame from top to bottom. As the pellicle frame (300, 300', 300", 300"') is lifted from top to bottom, the graphene membrane (200) adheres to the pellicle frame, and once dried, the manufacturing of the pellicle (2, 2') is complete.

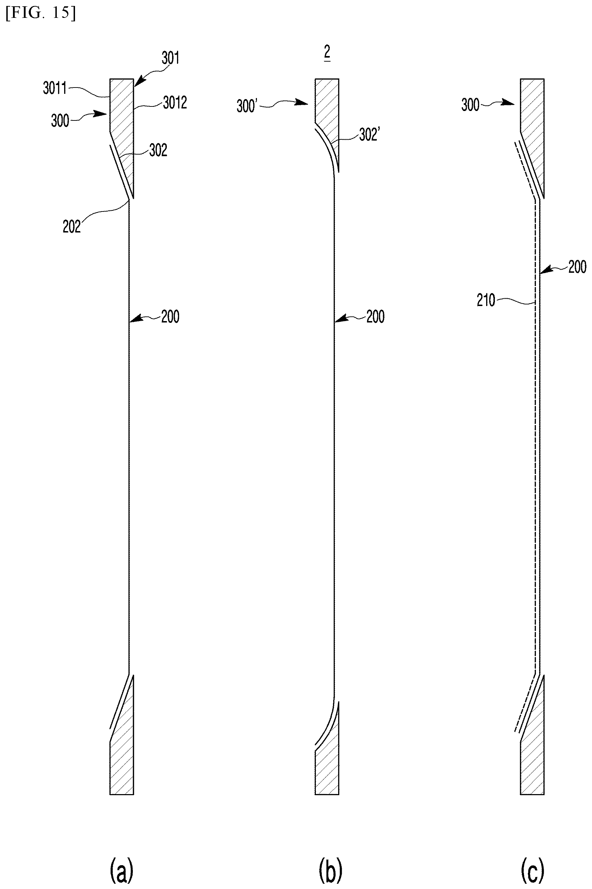

Fig. 14 shows the graphene membrane (200) attached to the back (3012) of the frame body (301) in the first embodiment (300) and the second embodiment (300') of the pellicle frame (Fig. 14(a), Fig. 14(b)), while Fig. 14(c) shows the graphene membrane (200) with a capping layer (210) formed on its surface attached to the frame body (301). Fig. 15 shows the graphene membrane (200) attached to the inclined surface part (302, 302') of the frame body (301) in the first embodiment (300) and second embodiment (300') of the pellicle frame (Fig. 15(a), Fig. 15(b)), and Fig. 15(c) shows the graphene membrane (200) with a capping layer (210) formed on its surface. Since the edges (3024, 3024') of the inclined surface part are formed at an acute angle, the edges are sharp, making it highly unlikely that water droplets will form on the edge of the inclined surface part.

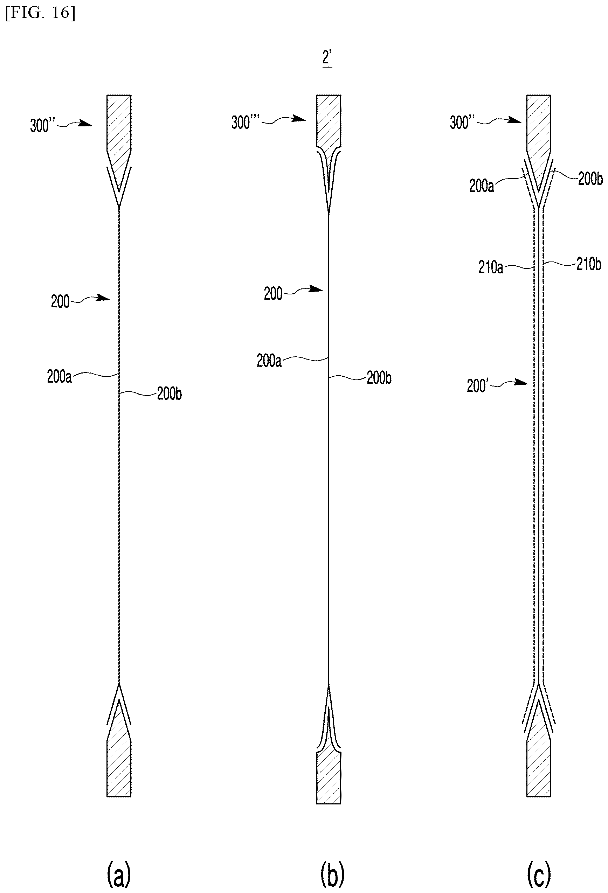

Fig. 16 shows the graphene membrane (200) attached to the third embodiment (300") and the fourth embodiment (300"') of the pellicle frame. Fig. 16(a) shows the graphene membrane (200) attached to the pellicle frame in the third embodiment (300"), and Fig. 16(b) shows the graphene membrane (200) attached to the pellicle frame in the fourth embodiment (300"'). Fig. 16(c) shows the graphene membrane (200) attached to the pellicle frame in the third embodiment (300"), with a capping layer (210 (210a, 210b)) formed on the surface of the graphene membrane (200). In Fig. 16, the graphene membrane (200) is shown attached to both sides of the pellicle frame, but it can be attached to either the front inclined surface part (302a", 302a"') or the rear inclined surface part (302b", 302b"'), or to both the front surface part and the rear inclined surface part. When the graphene membrane (200) is attached to both the front inclined surface part (302a", 302a"') and the rear inclined surface part (302b", 302b"'), the thickness of the graphene membrane (200) can double, reducing the need for further graphene stacking processes. For example, if the thickness of the graphene membrane (200) is 10 nm, attaching 5 nm graphene membranes on both sides will reduce the stacking process, thereby offering advantages in cost and labor savings. Furthermore, when the graphene membrane (200) with a capping layer (210) is attached to both sides of the frame body (301), the graphene membrane (200) is securely protected by the capping layer (210).

Fig. 2 is a structural diagram of the graphene stacking apparatus (1). As shown in the diagram, the graphene stacking apparatus (1) consists of: a supply roller section (10) comprising a thermal release tape supply roller (11) and a catalytic metal foil supply roller (12) with laminated graphene; a circulation section (20) for continuously circulating the thermal release tape where the graphene is transferred and stacked for a certain number of cycles; an etching section (30) for etching the catalytic metal foil during the circulation process; a washing section (40) for washing the etched graphene stacking film (100); a drying section (50) for drying the washed graphene stacking film (100); and a winding roller (60) for winding the thermal release tape (110) with the stacked graphene (122').

Referring to Figs. 2 to 4, the operation of the graphene stacking apparatus (1) is as follows: First, the thermal release tape (110) is supplied from the thermal release tape supply roller (11) to enable the circulation of the thermal release tape. The thermal release tape (110) rotates continuously via the first drive roller (21: 21a, 21b), the driven roller (22), and the second drive roller (23: 23a, 23b). As the thermal release tape (110) rotates, the graphene (122) and the catalytic metal foil (121) of the graphene-deposited film (120) are supplied from the graphene-deposited film supply roller (12) and attached to the thermal release tape (110). The graphene-deposited film (120) rotates with the thermal release tape (110), and since the graphene (122) deposited on the inner side of the graphene-deposited film (120) is transferred to the thermal release tape (110), the outer side graphene can be removed using a scraper (24). A tension roller (25) can also be included to maintain a constant tension in the thermal release tape (110) during circulation. After the graphene-deposited film (120) is attached to the thermal release tape (110), it rotates and enters the etching section (30), where the catalytic metal foil (121) of the graphene-deposited film (120) is removed by etching. The etching section (30) may consist of one or more etching units and may include a first etching section (30a) and a second etching section (30b) for complete removal of the catalytic metal foil. The etching section (30) consists of a tank (31) and an etching solution (32), as shown in the diagram. Since the thermal release tape (110) is immersed in the etching solution (32), it needs to be washed. Therefore, the washing section (40) sprays wash water to clean the thermal release tape (110), and the cleaned thermal release tape (110) is air-dried in the drying section (50). The dried thermal release tape (110) is continuously advanced by the second drive roller (23), and the sensor section (26) senses the rotation of the target (112) to determine whether the n-layer stacking is complete and sends a signal to the controller (not shown). Upon receiving the signal from the sensor section (26), the controller activates the cutter (27) to cut the graphene stacking film (100), and the cut graphene stacking film (100) is wound onto the winding roller (60).

Once the graphene stacking film (100) is wound onto the winding roller (60), it is entered to the thermal transfer step. Fig. 5 illustrates the thermal transfer process, in which the stacked graphene (122') is transferred from the graphene stacking film (100) to the substrate film (130). The thermal transfer section consists of a supply section (70), a thermal transfer section (90), and a winding section (80). The supply section (70) includes a graphene transfer film supply roller (71) and a substrate film supply roller (72) for supplying the substrate film (130). The thermal transfer section (90) consists of a chamber (91), an input thermal transfer roller (92), and an output thermal transfer roller (93), both mounted in the chamber (91). The winding section (80) consists of a thermal release tape winding roller (81) and a substrate film winding roller (82) to which the stacked graphene (122') is transferred. The graphene stacking film (100) is supplied via the thermal release tape supply roller (71), and the substrate film (130) is supplied via the substrate film supply roller (72). As they pass through the thermal transfer rollers (92, 93) in the thermal transfer section (90), the stacked graphene (122') is transferred to the substrate film (130), forming a graphene transfer film (100'). Figs. 6a and 6b show the stacked graphene (122') transferred from the thermal release tape (110) to the substrate film (130). Figs. 7a and 7b show the graphene transfer film (100') after heat treatment, forming the enhanced graphene transfer film (100"). Fig. 9 shows the graphene membrane (200) attached to the pellicle frame (300), forming the pellicle (2).

The present invention is not limited to the above embodiments, and it is apparent that those skilled in the art may carry out various modifications and changes within a scope that does not depart from the technical spirit of the invention.

### Industrial applicability

The present invention relates to a manufacturing method of a graphene membrane pellicle for EUV lithographic apparatus, which is used in the pattern formation process of semiconductor manufacturing, specifically in the EUV lithography process. In this regard, this invention has high industrial applicability.

## Claims

1. A manufacturing method of a graphene membrane pellicle for EUV lithographic apparatus, comprising:
(a) a graphene stacking film formation step in which the graphene from a graphene-deposited film, with graphene deposited on a catalytic metal foil, is transferred onto a thermal release tape and repetitively laminated to form stacked graphene;
(b) a graphene transfer film formation step in which the thermal release tape of the graphene stacking film is attached to a substrate film and the thermal release tape is thermally separated, thereby transferring the stacked graphene onto the substrate film;
(c) a stacked graphene heat treatment step in which a certain amount of heat is applied to the graphene transfer film to enhance the stacked graphene;
(d) a graphene transfer film cutting step in which the graphene transfer film with the enhanced stacked graphene is cut to a specified size according to the specifications of the pellicle frame;
(e) a graphene membrane formation step in which the substrate film is removed from the cut graphene transfer film, and the enhanced stacked graphene is separated to form a graphene membrane; and
(f) a graphene membrane attachment step in which the graphene membrane is attached to the pellicle frame.

2. The manufacturing method of a graphene membrane pellicle for EUV lithographic apparatus according to claim 1, wherein step (a) comprises:
(a-1) attaching the graphene deposition surface of the graphene-deposited film to the thermal release tape;
(a-2) immersing the thermal release tape with the attached graphene-deposited film into an etching solution to remove the catalytic metal foil and transfer the graphene onto the thermal release tape;
(a-3) washing the thermal release tape with the transferred graphene; and
(a-4) repeating steps (a-1) through (a-3) for n cycles to form a stacked graphene on the thermal release tape, with the graphene laminated n times to form the stacked graphene;
wherein the graphene stacking film is formed on the thermal release tape with the stacked graphene.

3. The manufacturing method of a graphene membrane pellicle for EUV lithographic apparatus according to claim 2, wherein the number of cycles, n, is between 2 and 100, and the thickness of the stacked graphene is between 5 and 100 nm.

4. The manufacturing method of a graphene membrane pellicle for EUV lithographic apparatus according to claim 3, wherein step (a) further comprises:
(a-5) attaching a capping material-deposited film, in which a capping material is deposited on the catalytic metal foil, to the stacked graphene surface of the graphene stacking film;
(a-6) immersing the graphene stacking film with the attached capping material-deposited film into an etching solution to remove the catalytic metal foil and form a capping layer on the surface of the stacked graphene; and
(a-7) washing the graphene stacking film with the formed capping layer.

5. The manufacturing method of a graphene membrane pellicle for EUV lithographic apparatus according to claim 1, wherein step (c) comprises:
(c-1) a residue treatment step of heating the graphene transfer film to a certain temperature to remove the residuals of the thermal release tape remaining on the stacked graphene; and
(c-2) a stacked graphene enhancement step of enlarging the graphene crystal size or depositing additional graphene on the residue-treated graphene transfer film.

6. The manufacturing method of a graphene membrane pellicle for EUV lithographic apparatus according to claim 5, wherein step (c) further comprises:
(c-3) a capping layer formation step of depositing a capping material on the surface of the enhanced stacked graphene of the graphene transfer film to form a capping layer.

7. The manufacturing method of a graphene membrane pellicle for EUV lithographic apparatus according to claim 1, wherein the substrate film is made of Cu or Ni.

8. The manufacturing method of a graphene membrane pellicle for EUV lithographic apparatus according to claim 1, wherein step (f) comprises:
(f-1) preparing the pellicle frame for attaching the graphene membrane;
(f-2) placing the graphene membrane horizontally on the surface of a tank filled with an aqueous solution;
(f-3) vertically inserting the pellicle frame into the aqueous solution; and
(f-4) lifting the pellicle frame vertically from the aqueous solution, attaching the graphene membrane from the top to the bottom of the membrane attachment surface of the pellicle frame.

9. The manufacturing method of a graphene membrane pellicle for EUV lithographic apparatus according to claim 8, wherein the pellicle frame comprises:
a frame body with a flat front and back, a through-hole formed in the center of the frame body, and an inclined surface part formed around the through-hole on the front of the frame body,
wherein the angle between the inclined surface part and the back of the frame body is formed as an acute angle.

10. The manufacturing method of a graphene membrane pellicle for EUV lithographic apparatus according to claim 9, wherein the graphene membrane is attached to the inclined surface part on the front or the back of the frame body to cover the through-hole.

11. The manufacturing method of a graphene membrane pellicle for EUV lithographic apparatus according to claim 8, wherein the pellicle frame comprises:
a frame body with a flat front and back, a through-hole formed in the center of the frame body, a front inclined surface part formed around the through-hole on the front of the frame body, and a rear inclined surface part formed around the through-hole on the back of the frame body.

12. The manufacturing method of a graphene membrane pellicle for EUV lithographic apparatus according to claim 11, wherein the front inclined surface part comprises:
an upper front inclined surface part, a lower front inclined surface part spaced a certain distance from the upper front inclined surface part, and side inclined surface part connecting both sides of the upper and lower inclined surfaces to form an inclined surface,
wherein the angle between the front inclined surface part and the front of the frame body is formed as an acute angle, and
wherein the graphene membrane is attached to the front inclined surface part to cover the through-hole.

13. The manufacturing method of a graphene membrane pellicle for EUV lithographic apparatus according to claim 11, wherein the rear inclined surface part comprises:
an upper rear inclined surface part, a lower rear inclined surface part spaced a certain distance from the upper rear inclined surface part, and side inclined surface part connecting both sides of the upper and lower inclined surfaces to form an inclined surface,
wherein the angle between the rear inclined surface part and the back of the frame body is formed as an acute angle, and
wherein the graphene membrane is attached to the rear inclined surface part to cover the through-hole.

14. The manufacturing method of a graphene membrane pellicle for EUV lithographic apparatus according to claim 1, wherein the graphene membrane has an extreme ultraviolet transmittance of 92 to 96% at a wavelength of 13.5 nm.
